(19) Europäisches Patentamt
European Patent Office
Office européen des brevets

(11) **EP 1 811 311 B1**

(12) **EUROPÄISCHE PATENTSCHRIFT**

(45) Veröffentlichungstag und Bekanntmachung des Hinweises auf die Patenterteilung:
**31.08.2016   Patentblatt 2016/35**

(51) Int Cl.:
*G01R 15/20* *(2006.01)*        *G01R 1/18* *(2006.01)*

(21) Anmeldenummer: **07100349.5**

(22) Anmeldetag: **10.01.2007**

(54) **Vorrichtung zur Strommessung**

Device for measuring current

Dispositif pour mesurer le courant

(84) Benannte Vertragsstaaten:
**DE FR IT**

(30) Priorität: **19.01.2006   CH 962006**
**08.05.2006   CH 7392006**
**14.06.2006   CH 9852006**

(43) Veröffentlichungstag der Anmeldung:
**25.07.2007   Patentblatt 2007/30**

(73) Patentinhaber: **Melexis Technologies NV**
**3980 Tessenderlo (BE)**

(72) Erfinder:
 • **Racz, Robert**
   **6300, Zug (CH)**
 • **Huber, Samuel**
   **80799, Muenchen (DE)**
 • **Gloor, Markus**
   **8134, Adliswil (CH)**

(74) Vertreter: **Falk, Urs**
**Patentanwaltsbüro Dr. Urs Falk**
**Eichholzweg 9A**
**6312 Steinhausen (CH)**

(56) Entgegenhaltungen:
**EP-A1- 0 233 988        EP-A1- 0 886 147**
**EP-A1- 1 443 332        EP-A2- 0 742 440**
**EP-A2- 0 772 046        CH-A5- 659 138**
**JP-A- 4 148 870         JP-A- 6 130 088**
**JP-A- 8 015 322         JP-A- 62 098 267**
**JP-A- H04 118 561**

**Beschreibung**

Die Erfindung betrifft eine Vorrichtung zur Strommessung der im Oberbegriff des Anspruchs 1 genannten Art.

Eine solche Vorrichtung zur Strommessung kann auch als Stromsensors bezeichnet werden, insbesondere dann, wenn sie im Handel als Produkt aus einem einzigen Teil verkauft werden kann. Ein solcher einteiliger Stromsensor ist bekannt aus der EP 772046. Der Stromsensor besteht aus einem Stromleiter, einem Magnetfeldsensor für die Messung des von einem durch den Stromleiter fliessenden Stromes erzeugten Magnetfelds und einem ferromagnetischen Joch. Der Magnetfeldsensor enthält einen Halbleiterchip mit zwei auf der Oberfläche des Halbleiterchips angeordneten Magnetfeldkonzentratoren, die durch einen Luftspalt getrennt sind, und zwei im Halbleiterchip integrierte horizontale Hallelemente, die beidseits des Luftspalts angeordnet sind, so dass sie von Feldlinien des Magnetfelds durchflutet werden, die vom ersten Magnetfeldkonzentrator in der Nähe des Luftspalts weggehen und auf den zweiten Magnetfeldkonzentrator in der Nähe des Luftspalts auftreffen. Der Halbleiterchip enthält zudem die für den Betrieb der Hallelemente und die Verstärkung und Auswertung der von den Hallelementen gelieferten Spannungssignale nötigen elektronischen Schaltungen. Der Magnetfeldsensor ist auf dem Stromleiter angeordnet, so dass die vom Strom erzeugten Magnetfeldlinien annähernd parallel zur Oberfläche des Halbleiterchips und damit auch parallel zu den Magnetfeldkonzentratoren verlaufen. Das Joch umschliesst den Stromleiter auf drei Seiten und bildet mit den beiden Magnetfeldkonzentratoren einen annähernd geschlossenen magnetischen Kreis. Das Joch und die beiden Magnetfeldkonzentratoren bilden einen magnetischen Verstärker, der das vom Strom erzeugte Magnetfeld verstärkt. Nachteile dieses Stromsensors sind, dass er sich aufgrund seiner Konstruktion als Stromsensor mit integriertem Stromleiter nur für die Messung relativ kleiner Ströme von bis zu 20A eignet und dass äussere magnetische Störfelder kaum abgeschirmt werden.

Aus der CH 659 138 ist eine Anordnung zum Messen des in einem Stromleiter fliessenden Stromes bekannt, bei der ein Schirm aus einem magnetischen Material mit hoher Permeabilität magnetische Störfelder abschirmt.

Der Erfindung liegt die Aufgabe zugrunde, eine Vorrichtung zur Strommessung zu entwickeln, die auf einfache Weise für die Messung von Strömen in einem relativ kleinen Messbereich von 0 bis typischerweise 20A oder 50A oder auch 100A, als auch für die Messung von Strömen in einem relativ grossen Messbereich von 0 bis 200A oder 300A ausgelegt werden kann, die kurzzeitig mit einem Überlaststrom von bis zu 1000A belastbar ist und die gut gegen äussere magnetische Störfelder abgeschirmt ist.

Die genannte Aufgabe wird erfindungsgemäss gelöst durch die Merkmale des Anspruchs 1. Weiterbildungen der Erfindung ergeben sich aus den abhängigen Ansprüchen.

Die Vorrichtung zur Strommessung umfasst einen Magnetfeldsensor für die Messung des von einem durch einen Stromleiter fliessenden Stroms erzeugten Magnetfelds und ein Joch aus einem magnetischen Material mit hoher Permeabilität, das den Stromleiter im Messbereich-umgibt. Das Joch besteht im Prinzip aus einem länglichen Stück Blech mit zwei Enden, das durch Abbiegen in eine Form gebracht worden ist, bei der die Stirnseiten des Blechs einander gegenüberliegen und durch einen Luftspalt getrennt sind. Das Joch ist also wie ein Stück Rohr mit einem in Rohrrichtung verlaufenden Schlitz. Das Joch umschliesst den Stromleiter mit Ausnahme des Luftspalts vollständig.

Der Magnetfeldsensor ist bevorzugt ein Magnetfeldsensor mit einem in einen Halbleiterchip integrierten Hallelement und einer in den Halbleiterchip integrierten elektronischen Schaltung für den Betrieb des Hallelementes und mit zwei auf der aktiven Oberseite des Halbleiterchips angeordneten, durch einen Luftspalt getrennten Magnetfeldkonzentratoren, wobei das Hallelement von Feldlinien des Magnetfeldes durchflutet wird, die vom ersten Magnetfeldkonzentrator in der Nähe des Luftspaltes weggehen und in der Nähe des Luftspaltes auf den zweiten Magnetfeldkonzentrator auftreffen.

Der Magnetfeldsensor kann aber auch ein anderer Sensor sein, z. B. ein AMR (anisotropic magnetic resistance) oder GMR (giant magnetic resistance) Sensor oder ein Fluxgate Sensor.

Das Joch dient einerseits der Verstärkung des vom Strom erzeugten Magnetfelds und andererseits der Abschirmung äusserer magnetischer Störfelder. Der Magnetfeldsensor und das Joch sind aufeinander abgestimmt derart, dass der Magnetfeldsensor nur empfindlich ist auf eine einzige Komponente des Magnetfelds, die beispielsweise als x-Komponente bezeichnet wird, und dass das Joch genau diese x-Komponente abschirmt. Der Magnetfeldsensor misst daher nur die x-Komponente des von dem im Stromleiter fliessenden Strom erzeugten Magnetfelds, nicht aber die abgeschirmte x-Komponente eines äusseren magnetischen Störfeldes. Um eine hohe Verstärkung zu erzielen, sind die Enden des Jochs verjüngt, so dass eine Breite der Enden des Jochs geringer als eine Breite des Jochs ist. Zudem ist die Ausdehnung des Jochs in der abzuschirmenden Richtung (also in der x-Richtung) mindestens so gross wie eine senkrecht dazu gemessene Höhe. Die Abschirmung kann weiter erhöht werden durch einen zusätzlichen, im wesentlichen u-förmigen, das Joch auf drei Seiten umschliessenden Schirm.

Das Verhältnis von Abschirmungsfaktor zu Verstärkungsfaktor kann auch erhöht werden, indem die Enden des Jochs entweder verbreitert und/oder mit einer Ausnehmung versehen werden. Eine solche Ausgestaltung des Jochs eignet sich auch für die Messung von Strömen in einem vergleichsweise grossen Bereich von 0 bis 200A oder 300A, aber auch 1000A.

Die Erfindung wird nachfolgend anhand von Ausführungsbeispielen und anhand der Zeichnung näher erläutert.

Die Figuren sind schematisch und nicht massstäblich gezeichnet.

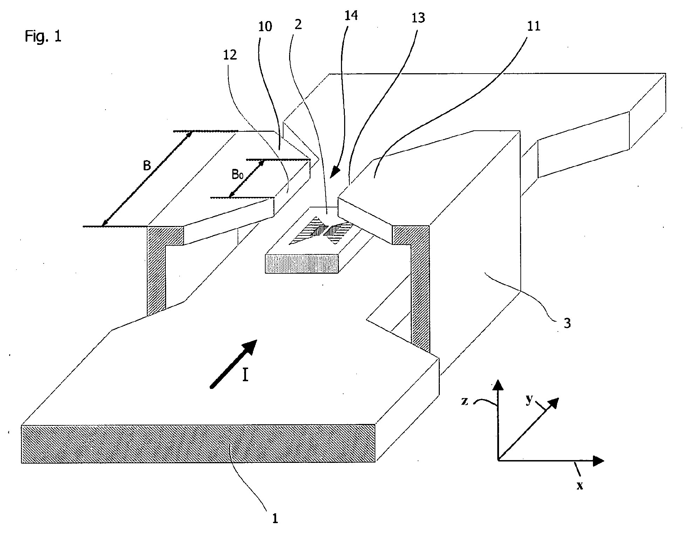

Es zeigen: Fig. 1    in perspektivischer Ansicht eine erfindungsgemässe Vorrichtung zur Strommessung mit einem Magnetfeldsensor und einem Joch,

Fig. 2    ein Beispiel eines bevorzugten Magnetfeldsensors,

Fig. 3    die Vorrichtung zur Strommessung im Querschnitt,

Fig. 4    eine weitere Vorrichtung zur Strommessung im Querschnitt,

Fig. 5    eine weitere Vorrichtung zur Strommessung im Querschnitt,

Fig. 6    Ausgangssignale der Vorrichtung zur Strommessung gemäss dem Ausführungsbeispiel der Fig. 5, und

Fig. 7, 8    in perspektivischer Ansicht weitere Vorrichtungen zur Strommessung mit dem Magnetfeldsensor und dem Joch.

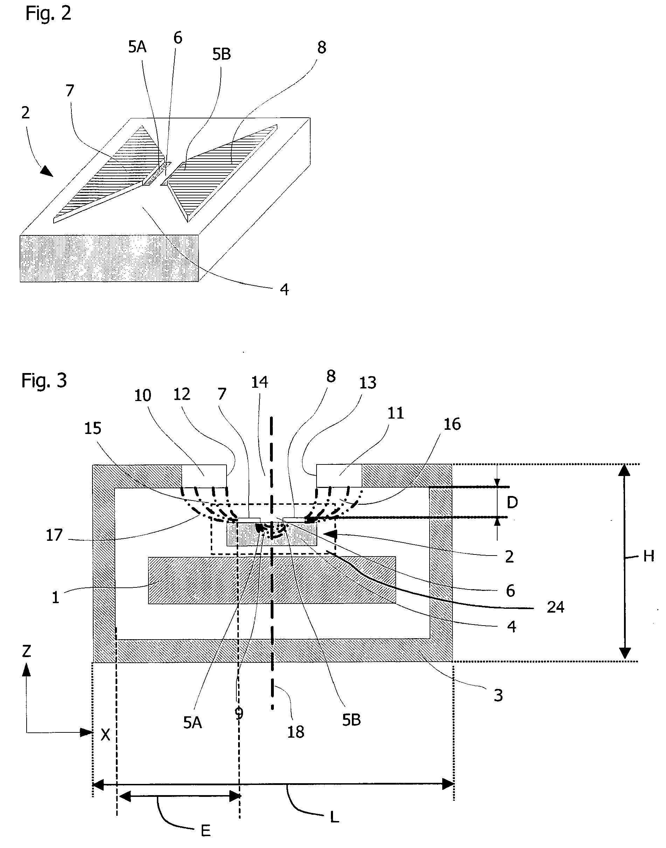

Die Fig. 1 und Fig. 3 zeigen in perspektivischer Ansicht bzw. Querschnitt eine Vorrichtung für die Messung des durch einen Stromleiter 1 fliessenden elektrischen Stroms I, die erfindungsgemäss ausgelegt ist für die Messung eines Stromes im Bereich von 0 bis typischerweise 20A oder 50A, im Maximum von etwa 100A. Der Querschnitt des Stromleiters 1 ist bevorzugt rechteckförmig. Die Koordinaten eines kartesischen Koordinatensystems sind mit x, y und z bezeichnet. Der Strom fliesst in y-Richtung. Die Vorrichtung zur Strommessung umfasst einen Magnetfeldsensor 2, der das Magnetfeld misst, das vom Strom I erzeugt wird, und ein Joch 3 aus einem Material mit hoher magnetischer Permeabilität. Unter hoher Permeabilität ist eine relative Permeabilität von wenigstens 100 zu verstehen (Die relative Permeabilität von Luft ist 1). Das Joch 3 ist beispielsweise aus einem Stück Blech aus Eisen oder Mumetall gebildet, deren relative Permeabilität typischerweise im Bereich zwischen 100 und 100'000 liegt. Das Joch 3 ist aus einem länglichen Stück Blech von etwa 0.5 bis 2 mm Dicke mit zwei Enden 10 und 11 derart geformt, dass es den Stromleiter 1 beinahe vollständig umschliesst, nämlich so, dass die beiden Stirnseiten 12 und 13 der Enden 10 und 11 des Blechs einander gegenüberliegen und durch einen Luftspalt 14 getrennt sind. Der Stromleiter 1 und der Magnetfeldsensor 2 befinden sich also vollständig innerhalb des Jochs 3. Die Enden 10 und 11 des Jochs 3 sind verjüngt, so dass ihre Breite $B_0$ geringer als die Breite B des Blechs bzw. Jochs 3 ist. Bevorzugt ist der Stromleiter 1 im Bereich des Jochs 3 verjüngt.

Ein bevorzugtes Beispiel für den Magnetfeldsensor 2 ist in der Fig. 2 näher dargestellt: Er enthält einen Halbleiterchip 4 mit mindestens einem Hallelement, im Beispiel zwei Hallelemente 5A und 5B, und eine elektronische Schaltung für den Betrieb des mindestens einen Hallelementes und die Auswertung der vom mindestens einen Hallelement gelieferten Hallspannung. Auf der aktiven Oberseite des Halbleiterchips 4, d.h. auf der Oberseite mit den integrierten Schaltkreisen, sind zwei durch einen Luftspalt 6 getrennte Magnetfeldkonzentratoren 7, 8 so angeordnet, dass das mindestens eine Hallelement von Feldlinien 9 (siehe Fig. 3) des Magnetfeldes durchflutet ist, die vom ersten Magnetfeldkonzentrator 7 in der Nähe des Luftspaltes 6 weggehen und in der Nähe des Luftspaltes 6 auf den zweiten Magnetfeldkonzentrator 8 auftreffen. Die Struktur eines solchen Magnetfeldsensors 2 ist aus dem europäischen Patent EP 772046 bekannt. Das Hallelement (bzw. die beiden Hallelemente 5A und 5B) ist ein sogenanntes horizontales Hallelement, das empfindlich ist auf ein Magnetfeld, das senkrecht zur aktiven Oberfläche des Halbleiterchips 4, hier also in z-Richtung verläuft. Unter dem Begriff Hallelement ist aber nicht nur ein einziges Hallelement zu verstehen, sondern es kann darunter auch eine Gruppe von parallel oder antiparallel geschalteten und/oder im Zeitmultiplex betriebenen Hallelementen verstanden werden. Solche Anordnungen von Hallelementen werden benutzt, um den Offset der Hallspannung zu reduzieren. Das Hallelement kann aber auch ein sogenanntes vertikales Hallelement sein, das empfindlich ist auf ein Magnetfeld, das parallel zur aktiven Oberfläche des Halbleiterchips 4 und senkrecht zur Stromrichtung, hier also in x-Richtung verläuft.

Der Magnetfeldsensor 2 ist in ein Gehäuse 24 verpackt. Der Magnetfeldsensor 2 ist (bei Abwesenheit des Jochs 3) empfindlich auf ein Magnetfeld, das in x-Richtung verläuft, und unempfindlich auf Magnetfelder, die in y- und z-Richtung verlaufen. Die beiden Magnetfeldkonzentratoren 7 und 8 erstrecken sich in x-Richtung. Das Gehäuse 24 benötigt mehr Platz als im Luftspalt 14 des Jochs 3 zur Verfügung steht. Das Gehäuse 24 befindet sich somit innerhalb des Jochs 3, aber ausserhalb des Luftspalts 14.

Der zwischen den Stirnseiten 12 und 13 der Enden 10 und 11 des Jochs 3 bestehende Luftspalt 14 befindet sich "oberhalb" des Luftspalts 6 zwischen den beiden Magnetfeldkonzentratoren 7 und 8, oder, geometrisch ausgedrückt: Es gibt eine senkrecht zur Oberfläche des Halbleiterchips 4 verlaufende Ebene, die sowohl durch den Luftspalt 6 als auch den Luftspalt 14 hindurch verläuft. Das Joch 3 und die beiden Magnetfeldkonzentratoren 7 und 8 bilden so einen durch den Luftspalt 6 und zwei weitere Luftspalte 15, 16 (siehe Fig. 3) unterbrochenen magnetischen Kreis, wobei Feldlinien 17 (siehe Fig. 3) des Magnetfelds, die vom ersten Ende 10 des Jochs 3 ausgehen, auf den ersten Magnetfeldkonzentrator 7 auftreffen, den Luftspalt 6 wie bekannt durchfluten und vom zweiten Magnetfeldkonzentrator 8 auf das zweite Ende 11 des Jochs 3 auftreffen. Die Vorrichtung zur Strommessung ist so konzipiert, dass sich die beiden Magnetfeldkonzentratoren 7 und 8 nicht direkt im Luftspalt 14 des Jochs 3, sondern unterhalb des Luftspalts 14 befinden, wo sie hauptsächlich von Streulinien des Magnetfeldes durchflutet werden, die von den Enden 10 und 11 des Jochs 3 ausgehen. Um dies zu erreichen, ist der Abstand D des Magnetfeldsensors 2, gemessen von Oberfläche der Magnetfeldkonzentratoren 7 und 8, vom Luftspalt 14 des Jochs 3 kleiner als ein Abstand E des Magnetfeldsensors 2, gemessen von dem äusseren Ende der Magnetfeldkonzentratoren 7 und 8, von den Seitenwänden des Jochs 3.

Das Joch 3 erfüllt zwei Funktionen, nämlich einerseits die magnetische Verstärkung des von dem im Stromleiter fliessenden Strom erzeugten Magnetfelds und andererseits die Abschirmung des Magnetfeldsensors gegen äussere magnetische Störfelder. Aufgrund seiner Konstruktion ist der Magnetfeldsensor 2 unempfindlich gegen äussere Magnetfelder, die in y- und/oder z-Richtung gerichtet sind. Die Verstärkung des von dem im Stromleiter fliessenden Strom erzeugten Magnetfelds am Ort des Hallelements wird durch einen Verstärkungsfaktor charakterisiert. Der Verstärkungsfaktor ist abhängig von der Geometrie des Jochs 3, aber auch von der Frequenz des Stroms 1. Im folgenden ist unter dem Verstärkungsfaktor in der Regel der Verstärkungsfaktor bei Gleichstrom bzw. Wechselströmen unterhalb einer bestimmten Grenzfrequenz $f_G$ gemeint. Die Effizienz der Abschirmung des Magnetfeldsensors 2 gegen ein äusseres, in x-Richtung gerichtetes Magnetfeld wird durch einen Abschirmungsfaktor charakterisiert. Die Verjüngung der Enden 10 und 11 auf die Breite $B_0$ bewirkt eine Erhöhung des Verstärkungsfaktors um den Faktor $B/B_0$, während der Abschirmungsfaktor nahezu unverändert bleibt. Der Verstärkungsfaktor und der Abschirmungsfaktor hängen vom Abstand des Magnetfeldsensors 2 vom Luftspalt 14 zwischen den Enden 10 und 11 des Jochs 3 ab. Dieser Sachverhalt wird anhand der Fig. 3 illustriert, die die Vorrichtung zur Strommessung im Querschnitt zeigt. Der Stromleiter 1 und das Joch 3 sind im Querschnitt rechteckförmig und symmetrisch bezüglich einer Symmetrieebene 18 angeordnet. Der Magnetfeldsensor 2 befindet sich auf der dem Luftspalt 14 des Jochs 3 zugewandten Seite des Stromleiters 1 und ist innerhalb von Montagetoleranzen ebenfalls symmetrisch bezüglich der Symmetrieebene 18 platziert, so dass die Symmetrieebene 18 auch durch den Luftspalt 6 zwischen den beiden Magnetfeldkonzentratoren 7 und 8 hindurch verläuft. Die Magnetfeldkonzentratoren 7 und 8 befinden sich im Abstand D vom Luftspalt 14 des Jochs 3. Mit zunehmendem Abstand D nimmt der Verstärkungsfaktor des Jochs 3 ab, da der Anteil der Feldlinien 17, die vom einen Ende 10 des Jochs 3 ausgehen und auf den Magnetfeldkonzentrator 7 gelangen, mit zunehmendem Abstand D abnimmt. Umgekehrt nimmt aus dem gleichen Grund der Abschirmungsfaktor des Jochs 3 mit zunehmendem Abstand D zu. Bei geeigneter Wahl des Abstands D beträgt der Verstärkungsfaktor typischerweise etwa 10, der Abschirmungsfaktor etwa 100 bis 1000.

Damit die Abschirmung eines in x-Richtung verlaufenden äusseren Magnetfelds wirksam ist, ist eine quer zum Stromleiter 1 und parallel zum Luftspalt 14 gemessene Länge L des Jochs 3 mindestens gleich gross wie eine senkrecht zum Luftspalt 14 gemessene Höhe H des Jochs 3. Bevorzugt ist die Länge L um mindestens den Faktor 1.5 grösser als die Höhe H.

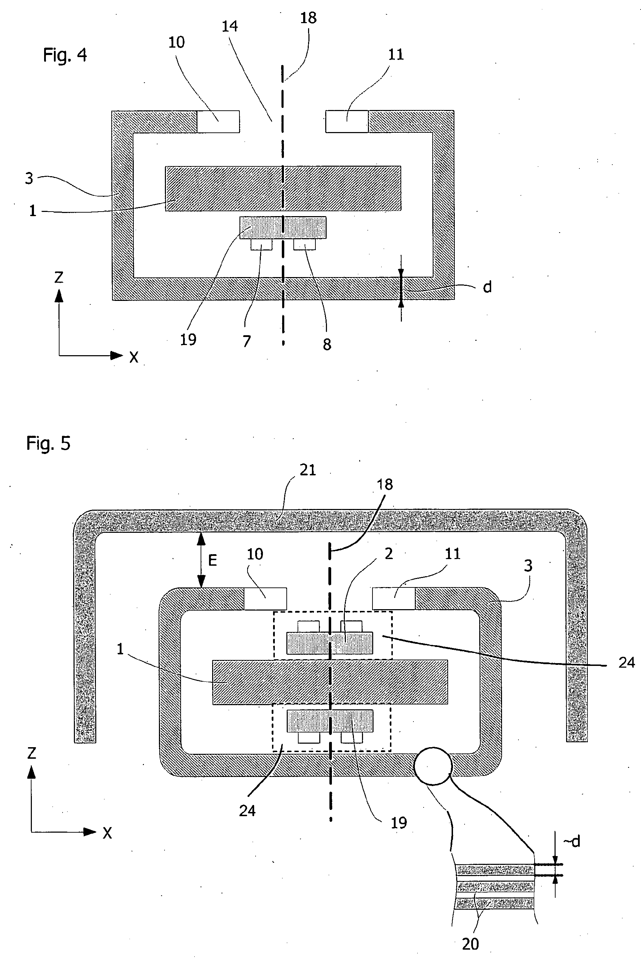

Die Fig. 4 zeigt eine Vorrichtung zur Strommessung, bei der ein Magnetfeldsensor 19 auf der dem Luftspalt 14 des Jochs 3 abgewandten Seite des Stromleiters 1 angeordnet ist. Der Magnetfeldsensor 19 ist der gleiche wie der Magnetfeldsensor 2 beim vorhergehenden Beispiel. Der Abschirmungsfaktor für den Magnetfeldsensor 19 ist auch hier sehr gross. Der Verstärkungsfaktor des Jochs 3 für den Magnetfeldsensor 19 liegt jedoch zwischen 0 und 1, d.h. das Joch 3 verstärkt das Magnetfeld am Ort des zweiten Magnetfeldsensors 19 nicht, sondern reduziert das Magnetfeld sogar, wenn der Verstärkungsfaktor kleiner als 1 ist. Wenn der Verstärkungsfaktor kleiner als 1 ist, lässt sich dies ausnutzen, um den Frequenzgang des Magnetfeldsensors 19 zu verbessern. Das Ausgangssignal des Mägnetfeldsensors 19 ohne Joch 3 in Abhängigkeit der Frequenz des Stroms ist in einem Frequenzbereich von 0 bis $f_{G1}$ konstant ($f_{G1}$ beträgt beispielsweise 50 kHz) und fällt dann typischerweise mit 20dB/Oktave ab. Das Joch 3 verändert den Frequenzgang, weil der Verstärkungsfaktor des Jochs 3 oberhalb einer Grenzfrequenz $f_{G2}$ ebenfalls absinkt. Wenn der Verstärkungsfaktor des Jochs 3 für Gleichströme jedoch bereits geringer als 1 ist, dann wirkt sich die Abschwächung des Verstärkungsfaktors oberhalb der Grenzfrequenz $f_{G2}$ weniger stark aus, so dass oberhalb der Grenzfrequenz $f_{G2}$ insgesamt eine geringere Abschwächung auftritt. Dieser Effekt lässt sich ausnützen, um den Frequenzgang des Stromsensors zu verbessern. Im gezeigten Beispiel besteht das Joch 3 aus einem einzigen Stück Blech. Die Grenzfrequenz $f_{G2}$ des Jochs 3 hängt ab von der Dicke d des Blechs:

$$f_{G2} \sim \frac{1}{d}$$

Die Dicke d des Blechs wird nun so gewählt, dass $f_{G2}$ annähernd gleich $f_{G1}$ ist. Mit abnehmender Dicke des Blechs und somit des Jochs 3 wird aber auch das Magnetfeld kleiner, das das Joch 3 magnetisch in Sättigung bringt. Um dies zu vermeiden, wird das Joch 3 als Laminat aus mehreren durch eine Isolationsschicht getrennten Blechen der Dicke d gebildet. Die Dicke d eines Blechs beträgt typischerweise etwa 0.02 bis 0.1, maximal 0.2 mm.

Die Fig. 5 zeigt eine Vorrichtung zur Strommessung, bei der der Magnetfeldsensor 2 auf der dem Luftspalt 14 des Jochs 3 zugewandten Seite des Stromleiters 1 und der Magnetfeldsensor 19 auf der dem Luftspalt 14 des Jochs 3 abgewandten Seite des Stromleiters 1 angeordnet ist. Der erste Magnetfeldsensor 2 dient für die genaue Messung des Stroms in einem vorgegebenen Arbeitsbereich von typischerweise 0 bis 50A oder 0 bis 100A, während der zweite Magnetfeldsensor 19 für die Messung des Stroms oberhalb des vorgegebenen Arbeitsbereichs, in einem vorgegebenen Überlastbereich von hier entsprechend 50A bzw. 100A bis typischerweise 1000A, dient. Bei diesem Beispiel ist das Joch 3 als Laminat aus durch Isolationsschichten getrennten Blechen 20 dargestellt.

Bei allen Beispielen kann der Abschirmungsfaktor durch einen zusätzlichen, im wesentlichen u-förmigen Schirm 21 aus einem Material mit hoher magnetischer Permeabilität vergrössert werden, der das Joch 3 auf drei Seiten umschliesst. Der Schirm 21 besteht aus drei Abschnitten, von denen der mittlere Abschnitt parallel zum Luftspalt 14 des Jochs 3 verläuft. Der Schirm 21 besteht vorzugsweise aus dem gleichen Material wie das Joch 3. Der Schirm 21 ist im Abstand E zum Joch 3 angeordnet. Der Abstand E ist so gross bemessen, dass der Schirm 21 den Verstärkungsfaktor des Jochs 3 nicht oder nur unwesentlich verkleinert.

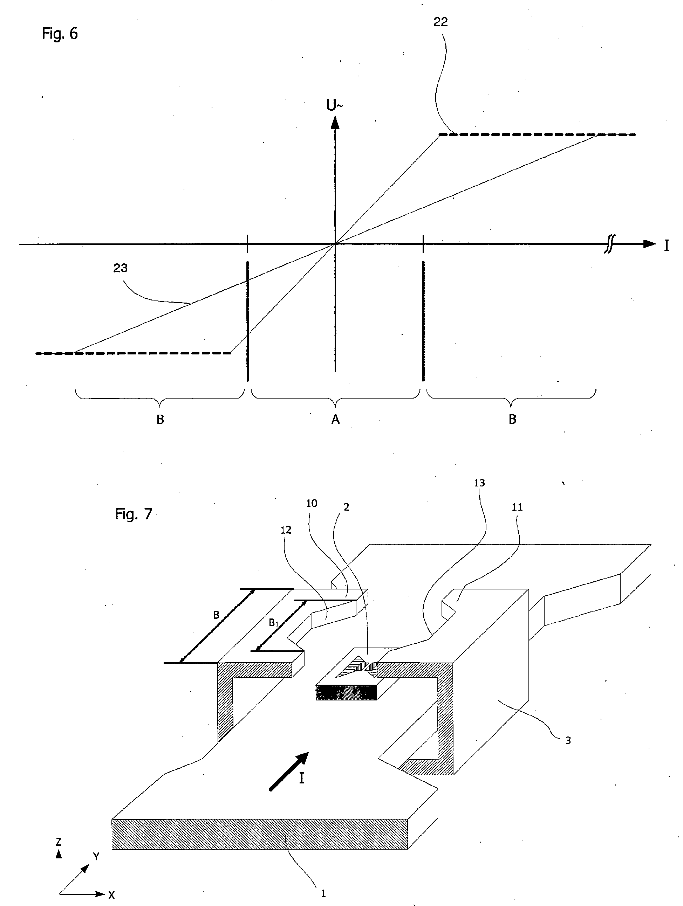

Die Fig. 6 zeigt die Ausgangssignale 22 und 23 der beiden Magnetfeldsensoren 2 und 19 in Funktion des im Stromleiter 1 fliessenden Stroms I. Das Ausgangssignal 22 des ersten Magnetfeldsensors 2 ist proportional zum Strom I im vorgegebenen Arbeitsbereich A. Oberhalb des Arbeitsbereichs A treten Sättigungseffekte der Magnetfeldkonzentratoren 7, 8 des ersten Magnetfeldsensors 2 auf, die eine Abflachung des Ausgangssignals 22 bewirken. Das Ausgangssignal 23 des zweiten Magnetfeldsensors 19 ist proportional zum Strom I im Überlastbereich B, da infolge des geringeren Verstärkungsfaktors Sättigungseffekte der Magnetfeldkonzentratoren 7, 8 des zweiten Magnetfeldsensors 19 erst bei Strömen oberhalb der oberen Grenze des Überlastbereichs B auftreten.

Die erfindungsgemässe Vorrichtung zur Strommessung zeichnet sich durch einen einfachen, kompakten Aufbau und eine einfache Montage aus. Das Gehäuse 24 mit dem Magnetfeldsensor 2 kann direkt auf den Stromleiter 1 geklebt werden. Alternativ kann das Gehäuse 24 auf einer Leiterplatte montiert und die Leiterplatte auf dem Stromleiter 1 befestigt werden. Ebenso kann das Joch 3 auf der gegenüberliegenden Seite direkt oder allenfalls über einen zusätzlichen Abstandshalter am Stromleiter 1 angeklebt werden.

Der Magnetfeldsensor 2 bzw. 19 soll im wesentlichen nur empfindlich sein auf die x-Komponente eines äusseren Magnetfelds und unempfindlich auf die y- und z-Komponente des äusseren Magnetfelds. Der oben beschriebene Magnetfeldsensor mit den beiden Magnetfeldkonzentratoren und dem Halleelement erfüllt diese Anforderungen in hohem Masse. Der Magnetfeldsensor 2 bzw. 19 kann aber bei allen Beispielen auch ein anderer Sensor sein, der diese Anforderung erfüllt, z. B. ein AMR (anisotropic magnetic resistance) oder GMR (giant magnetic resistance) Sensor. Diese Sensoren umfassen ein ferromagnetisches Widerstandselement, dessen elektrischer Widerstand von der Stärke des Magnetfelds abhängt. Der Magnetfeldsensor 2 bzw. 19 kann des weiteren auch ein Fluxgate Sensor sein. Ein Fluxgate Sensor umfasst einen ferromagnetischen Kern. Das ferromagnetische Widerstandselement bzw. der ferromagnetische Kern ist auf der aktiven Oberfläche des Halbleiterchips 4 angeordnet. Das ferromagnetische Widerstandselement bzw. der ferromagnetische Kern beeinflusst den Verlauf der magnetischen Feldlinien in ähnlicher Weise wie die Magnetfeldkonzentratoren 7, 8 beim vorhergehenden Beispiel.

Es sind auch abgewandelte Formen des Jochs möglich. Die beiden verjüngten, einander gegenüberliegenden Enden des Jochs könnten z. B. auch in der Form von aus den Seitenwänden des Jochs freigestanzten und abgebogenen Zungen bestehen.

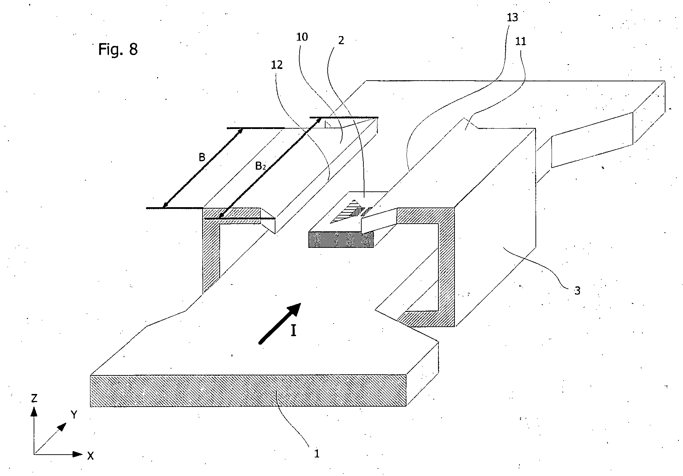

Die Fig. 7 und Fig. 8 zeigen in perspektivischer Ansicht zwei Vorrichtungen zur Strommessung, die erfindungsgemäss ausgelegt sind für die Messung von Strömen in einem grösseren Bereich von 0 bis 200A oder 300A. Bei diesen Vorrichtungen sind die Enden des Jochs 3 so ausgestaltet, dass das Magnetfeld am Ort des Magnetfeldsensors 2 kleiner ist als bei einer Vorrichtung zur Strommessung mit einem Joch 3, dessen Enden weder verjüngt, noch verbreitert, noch mit einer Ausnehmung versehen sind, die also eine gerade Stirnseite mit der Breite B aufweisen. Beim Ausführungsbeispiel der Fig. 7 weisen die Enden 10 und 11 des Jochs 3 die Breite B auf, die Stirnseiten 12 und 13 des Jochs 3 sind aber mit einer Ausnehmung der Breite $B_1$ versehen. Beim Ausführungsbeispiel der Fig. 8 sind die Enden 10 und 11 des Jochs 3 auf die Breite $B_2$ verbreitert. Möglich ist auch eine Kombination, d.h. eine Verbreiterung der Enden auf die Breite $B_2 > B$ und die Anbringung einer Ausnehmung der Breite $B_1$. Der Verstärkungsfaktor des Jochs 3 wird auf diese Weise deutlich verringert, während der Abschirmungsfaktor geringfügig ändert. Auf diese Weise kann einerseits das Verhältnis von Abschirmungsfaktor zu Verstärkungsfaktor erhöht und andererseits der Verstärkungsfaktor verkleinert werden.

Die gezeigten Beispiele illustrieren, dass die Vorrichtung zur Strommessung einzig durch Änderung der Form der Enden des Jochs 3 für die Messung unterschiedlich grosser Maximalströme ausgelegt werden kann. Der gleiche Magnetfeldsensor 2 kann auf die gleiche Weise und an der gleichen Position auf dem Stromleiter 1 montiert werden.

**Patentansprüche**

1. Vorrichtung zur Strommessung, mit einem in einem Gehäuse (24) verpackten Magnetfeldsensor (2) für die Messung des von einem durch einen Stromleiter (1) fliessenden Stroms erzeugten Magnetfelds und einem Joch (3) aus einem magnetischen Material mit einer relativen Permeabilität von wenigstens 100, wobei der Stromleiter (1) einen rechteckförmigen Querschnitt und eine Unterseite und eine Oberseite hat, wobei in Bezug auf ein kartesisches Koordinatensystem mit drei als x-Achse, y-Achse und z-Achse bezeichneten Achsen sich der Stromleiter (1) in Richtung der y-Achse erstreckt, in die der Strom fliesst, und der Magnetfeldsensor (2) empfindlich ist auf diejenige Komponente des Magnetfelds, die sich in Richtung der x-Achse erstreckt, wobei das Joch (3) aus einem länglichen Stück Blech oder aus einem Laminat mit durch Isolationsschichten getrennten Blechen gebildet und durch Biegen derart geformt ist, dass das Joch (3) zwei Seitenwände, die sich in Richtung der z-Achse erstecken, und zwei durch einen Luftspalt (14) getrennte Enden (10, 11) aufweist, deren Stirnseiten (12, 13) einander gegenüberliegen, so dass das Joch (3) den Stromleiter (1) mit Ausnahme des Luftspalts (14) vollständig umschliesst, wobei das Joch in Richtung der x-Achse gemessen eine Länge (L) und in Richtung der z-Achse gemessen eine Höhe (H) aufweist, das Gehäuse (24) mit dem Magnetfeldsensor (2) innerhalb des Jochs (3) und ausserhalb des Luftspalts (14) des Jochs (3) angeordnet und auf die Oberseite des Stromleiters (1) geklebt oder auf einer Leiterplatte montiert und die Leiterplatte auf der Oberseite des Stromleiters (1) befestigt ist, der Magnetfeldsensor (2) wenigstens ein Hallelement (5A; 5B) und zwei Magnetfeldkonzentratoren (7, 8) umfasst oder ein AMR oder GMR Sensor ist, der ein ferromagnetisches Widerstandselement umfasst, oder ein Fluxgate Sensor ist, der einen ferromagnetischen Kern umfasst, wobei die Magnetfeldkonzentratoren (7, 8) bzw. das ferromagnetische Widerstandselement bzw. der ferromagnetische Kern hauptsächlich von Streulinien des Magnetfelds durchflutet werden, die von den Enden (10, 11) des Jochs (3) ausgehen, die Länge (L) des Jochs (3) mindestens gleich gross wie die Höhe (H) des Jochs (3) ist, der Magnetfeldsensor (2) in einem von der Oberfläche der Magnetfeldkonzentratoren (7, 8) bzw. des ferromagnetischen Widerstandselements bzw. des ferromagnetischen Kerns entlang der z-Achse gemessenen Abstand (D) vom Luftspalt (14) des Jochs (3) angeordnet ist, wobei der Abstand (D) kleiner als ein von dem äusseren Ende der Magnetfeldkonzentratoren (7, 8) bzw. des ferromagnetischen Widerstandselements bzw. des ferromagnetischen Kerns entlang der x-Achse gemessener kürzester Abstand (E) des Magnetfeldsensors (2) von den Seitenwänden des Jochs (3) ist, und das Joch (3) direkt oder über einen Abstandshalter auf die Unterseite des Stromleiters (1) geklebt ist.

2. Vorrichtung zur Strommessung nach Anspruch 1, **dadurch gekennzeichnet, dass** die Enden (10, 11) des Jochs (3) verjüngt sind.

3. Vorrichtung zur Strommessung nach Anspruch 1, **dadurch gekennzeichnet, dass** die Enden (10, 11) des Jochs (3) verbreitert oder mit einer Ausnehmung versehen oder verbreitert und mit einer Ausnehmung versehen sind.

4. Vorrichtung zur Strommessung nach einem der Ansprüche 1 bis 3, **dadurch gekennzeichnet, dass** auf der dem Luftspalt (14) des Jochs (3) abgewandten Seite des Stromleiters (1) ein weiterer Magnetfeldsensor (19) angeordnet ist.

5. Vorrichtung zur Strommessung nach einem der Ansprüche 1 bis 4, **dadurch gekennzeichnet, dass** der Magnetfeldsensor (2; 19) einen Halbleiterchip (4) mit mindestens einem Hallelement (5A; 5B) umfasst, wobei auf einer Oberseite des Halbleiterchips (4) zwei durch einen weiteren Luftspalt (6) getrennte Magnetfeldkonzentratoren (7, 8) angeordnet sind, wobei das Hallelement (5A; 5B) von Feldlinien (9) des Magnetfeldes durchflutet ist, die vom ersten Magnetfeldkonzentrator (7) in der Nähe des weiteren Luftspaltes (6) weggehen und in der Nähe des weiteren Luftspaltes (6) auf den zweiten Magnetfeldkonzentrator (8) auftreffen.

6. Vorrichtung zur Strommessung nach einem der Ansprüche 1 bis 5, die zusätzlich einen im wesentlichen u-förmigen, das Joch (3) auf drei Seiten umschliessenden Schirm (21) aus einem magnetischen Material mit einer relativen Permeabilität von wenigstens 100 umfasst, wobei der Schirm (21) drei Abschnitte aufweist, von denen der mittlere Abschnitt parallel zum Luftspalt (14) des Jochs (3) verläuft.

## Claims

1. Device for measuring current, comprising a magnetic field sensor (2) for measuring a magnetic field produced by a current flowing through a current conductor (1), the magnetic field sensor encapsulated into a housing (24), and a yoke (3) of a magnetic material having a relative permeability of at least 100, wherein the current conductor (1) has a rectangular cross section and a bottom side and a top side, wherein the current conductor (1) extends in relation to a Cartesian coordinate system having three axes designated as x-axis, y-axis and z-axis in the direction of the y-axis, in which the current flows, and the magnetic field sensor (2) is sensitive to that component of the magnetic field which extends in the direction of the x-axis, wherein the yoke (3) is formed of an oblong piece of sheet metal or a laminate of sheet metals and is formed by bending such that the yoke (3) has two sidewalls extending in the direction of the z-axis and two ends (10, 11) separated by an air gap (14), the front faces of which face each other, so that the yoke (3) completely circumscribes the current conductor (1) with the exception of the air gap (14), wherein the yoke has a length (L) measured in the direction of the x-axis and a height (H) measured in the direction of the y-axis, the housing (24) with the magnetic field sensor (2) is placed inside the yoke (3) and outside the air gap (14) of the yoke (3) and glued on the top side of the current conductor (1) or mounted on a printed circuit board and the printed circuit board fixed on the top side of the current conductor (1), the magnetic field sensor (2) comprises at least one Hall element (5A; 5B) and two magnetic field concentrators (7, 8) or is an AMR or GMR sensor, which comprises a ferromagnetic resistive element, or is a fluxgate sensor, which comprises a ferromagnetic core, wherein the magnetic field concentrators (7, 8) or the ferromagnetic resistive element or the ferromagnetic core are essentially passed through by stray lines of the magnetic field that issue from the ends (10, 11) of the yoke (3), the length (L) of the yoke (3) is at least the same size as the height (H) of the yoke (3), the magnetic field sensor (2) is placed at a distance (D) from the air gap (14) of the yoke (3) which is measured from the surface of the magnetic field concentrators (7, 8) or the ferromagnetic resistive element or the ferromagnetic core, wherein the distance (D) is less than a smallest distance (E) from the sidewalls of the yoke (3) which smallest distance is measured along the x-axis from the outer end of the magnetic field concentrators (7, 8) or the ferromagnetic resistive element or the ferromagnetic core, and the yoke (3) is secured directly or with distance keeping means to the bottom side of the current conductor (1).

2. Device for measuring current according to claim 1, **characterized in that** the ends (10, 11) of the yoke (3) are tapered.

3. Device for measuring current according to claim 1, **characterized in that** the ends (10, 11) of the yoke (3) are enlarged or provided with a recess or are enlarged and provided with a recess.

4. Device for measuring current according to any of claims 1 to 3, **characterized in that** a further magnetic field sensor (19) is placed on the side of the current conductor (1) that faces the bottom side of the yoke (3).

5. Device for measuring current according to any of claims 1 to 4, **characterized in that** the magnetic field sensor (2; 19) comprises a semiconductor chip (4) with at least one Hall element (5A; 5B), wherein two magnetic field concentrators (7, 8) are arranged on a top side of the semiconductor chip (4) wherein the Hall element (5A; 5B) is passed through by field lines (9) of the magnetic field that issue from the first magnetic field concentrator (7) in the vicinity of the further air gap (6) and impinge on the second magnetic field concentrator (8) in the vicinity of the further air gap (6).

6. Device for measuring current according to any of claims 1 to 5, further comprising an essentially u-shaped screen (21) of a magnetic material with a relative permeability of at least 100 that borders the yoke (3) on three sides, wherein the screen (21) has three sections of which the middle section runs parallel to the air gap (14) of the yoke (3).

**Revendications**

1. Dispositif de mesure du courant avec un capteur de champ magnétique (2) renfermée dans un boîtier (24) pour la mesure d'un champ magnétique généré par un courant passant par un conducteur (1) et une culasse (3) en matériau magnétique avec une perméabilité relative d'au moins 100, sachant que le conducteur (1) possède une section carrée, une face inférieure et une face supérieure, sachant que par rapport à un système de coordonnées cartésien avec trois axes désignés axe x, axe y et axe z, le conducteur (1) s'étend dans le sens de l'axe y, dans lequel le courant passe et le capteur de champ magnétique (2) est sensible aux composants du champ magnétique qui s'étend dans le sens de l'axe x, sachant que la culasse (3) est composée par un long morceau de tôle ou un stratifié avec des tôles séparées par des couches d'isolation formé par courbage de telle sorte que la culasse (3) présente deux parois latérales qui s'étendent dans le sens de l'axe z et deux extrémités (10, 11) séparées par un entrefer (14) dont les faces d'extrémité (12, 13) se font face de telle sorte que la culasse (3) enveloppe totalement le conducteur (1) à l'exception de l'entrefer (14), sachant que la culasse présente une longueur (L) mesurée dans le sens de l'axe x et une hauteur (H) mesurée dans le sens d'axe z, le boîtier (24) avec le capteur de champ magnétique (2) est disposé dans la culasse (3) et hors de l'entrefer (14) de la culasse (3) et est collé sur la face supérieure du conducteur (1) ou monté sur un circuit imprimé lui-même fixé sur la face supérieure du conducteur (1), le capteur de champ magnétique (2) comporte au moins un élément à effet Hall (5A; 5B) et deux concentrateurs magnétiques (7, 8) ou est un capteur AMR ou GMR qui englobe un élément de résistance ferromagnétique, ou est un capteur Fluxgate qui englobe un noyau ferromagnétique, sachant que les concentrateurs ferromagnétiques (7, 8) ou l'élément de résistance ferromagnétique ou le noyau ferromagnétique est essentiellement parcouru par des lignes de dispersion du champ magnétique qui partent des extrémités (10, 11) de la culasse (3), la longueur (L) de la culasse (3) est au moins égale à la hauteur (H) de la culasse (3), le capteur de champ magnétique (2) est disposée à une distance (D) de l'entrefer (14) de la culasse (3) mesurée à partir de la surface des concentrateurs magnétiques (7, 8) ou de l'élément de résistance ferromagnétique ou du noyau le long de l'axe z, sachant que la distance (D) est inférieure à la distance la plus courte (E) du capteur de champ magnétique (2) avec les parois latérales de la culasse (3) mesurée à partir de l'extrémité extérieure des concentrateurs magnétiques (7, 8) ou de l'élément de résistance ferromagnétique ou du noyau ferromagnétique le long de l'axe x et la culasse (3) est collée directement ou avec un écarteur sur la face inférieure du conducteur (1).

2. Dispositif de mesure du courant selon la revendication 1, **caractérisé en ce que** les extrémités (10, 11) de la culasse (3) sont diminuées.

3. Dispositif de mesure du courant selon la revendication 1, **caractérisé en ce que** les extrémités (10, 11) de la culasse (3) sont élargies ou pourvues d'une cavité ou élargies et pourvues d'une cavité.

4. Dispositif de mesure du courant selon l'une des revendications 1 à 3, **caractérisé en ce que** sur la face du conducteur (1) opposée à l'entrefer (14) de la culasse (3), un autre capteur de champ magnétique (19) est disposé.

5. Dispositif de mesure du courant selon l'une des revendications 1 à 4, **caractérisé en ce que** le capteur de champ magnétique (2; 19) englobe une puce semi-conductrice (4) avec au moins un élément à effet Hall (5A; 5B), sachant que sur une face supérieure de la puce semi-conductrice (4), sont disposés deux concentrateurs magnétiques (7, 8) séparés par un autre entrefer (6), sachant que l'élément à effet Hall (5A; 5B) est parcouru par des lignes de champ (9) du champ magnétique qui partent du premier concentrateur magnétique (7) à proximité de l'autre entrefer (6) et sortent à proximité de l'autre entrefer (6) sur le deuxième concentrateur magnétique (8).

6. Dispositif de mesure du courant selon l'une des revendications 1 à 5 qui comporte également un écran (21) en forme de U enveloppant la culasse (3) par trois côtés en matériau magnétique d'une perméabilité relative d'au moins 100, sachant que l'écran (21) présente trois sections à partir desquelles la section centrale s'étend parallèllement à l'entrefer (14) de la culasse (3).

Fig. 1

Fig. 2

Fig. 3

Fig. 4

Fig. 5

Fig. 6

Fig. 7

Fig. 8

**EP 1 811 311 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 772046 A

- CH 659138